Europäisches Patentamt

European Patent Office

Office européen des brevets

(19)

(11) Publication number: **0 159 758**
A1

(12) # EUROPEAN PATENT APPLICATION

(21) Application number: **85200580.0**

(22) Date of filing: **16.04.85**

(51) Int. Cl.⁴: **H 01 L 27/14**

(30) Priority: **24.04.84 NL 8401312**

(43) Date of publication of application: **30.10.85**
**Bulletin 85/44**

(84) Designated Contracting States: **AT BE DE FR GB IT**

(71) Applicant: **N.V. Philips' Gloeilampenfabrieken,
Groenewoudseweg 1, NL-5621 BA Eindhoven (NL)**

(72) Inventor: **Theuwissen, Albert Joseph Pierre, c/o Int.
Octrooibureau B.V. Prof. Holstlaan 6, NL-5656 AA
Eindhoven (NL)**

(74) Representative: **Houbiers, Ernest Emile Marie Gerlach et
al, INTERNATIONAAL OCTROOIBUREAU B.V. Prof.
Holstlaan 6, NL-5656 AA Eindhoven (NL)**

(54) **Charge-coupled device.**

(57) The invention relates to an n-phase charge-coupled device having parallel inputs (23), more particularly a line sensor comprising a linear array of photosensitive elements (pixels) (20) which are coupled to the charge-coupled device via the parallel inputs. The pitch between the parallel inputs and hence also the pitch between the pixels is smaller than n. The clock electrodes (1–13) are connected to control circuits by which during the introduction of the charge packets a potential well is induced in the charge transport channel for each parallel input and by which for the charge transport a gradually increasing part of the charge-coupled device is clocked. By this instruction, with unchanged number of clock electrodes, the pixel density can be increased, or with unchanged number of pixels, the number of clock electrodes can be reduced.

EP 0 159 758 A1

Charge-coupled device.

The invention relates to a charge-coupled device comprising a semiconductor body having a surface-adjoining semiconductor region in which a charge transport channel is defined for storing and transporting information-representing discrete charge packets, the device further comprising a system of clock electrodes which are located above the charge transport channel and which are connected to means for supplying clock signals for transporting the said charge packets from a first position in the charge transport channel to a second position in such a manner that per $n$ successive clock electrodes only one charge packet is present, $n$ being an integer and larger than or equal to 2, the charge transport channel further being provided with a plurality of parallel·inputs which each correspond to at least one of the said clock electrodes and by means of which charge packets can be introduced in parallel into the charge transport channel.

This application is related to concurrently filed applications entitled "Charge-coupled semiconductor device and image sensor device of high information density" (PHN 10.698) and "Charge-coupled semiconductor device with dynamic control" (PHN 10.997), and assigned to the same assignee as this application and incorporated by reference herein. The application "Charge-coupled semiconductor device with dynamic control" discloses apparatus which if substituted for its counterpart in this application is judged to be the best mode of practicing the invention of this application.

A known type of charge-coupled device having parallel inputs is the line sensor. This device comprises a row of photosensitive elements which are provided in the semiconductor body and by which a radiation pattern can be converted into a corresponding series of electrical signals. Via the parallel inputs, which are each associated with a photosensitive element, the electrical signals can be introduced as charge packets into the charge transport channel and can be read out in series for further signal processing at the output of the charge-coupled device. Such a line sensor can be extended in a simple manner to a two-dimensional image sensor of the so-called interline type by arranging a number of rows of photosensitive elements beside each other as columns of a frame and by providing between each column a charge-coupled device for reading out.

A two-dimensional image sensor device mostly comprises a horizontal series reading-out register in the form of a charge-coupled device having parallel inputs. These inputs can each again be associated with a vertical register. Via the inputs each time a line of the frame can be shifted into the horizontal register and can be read out via this register. Such a horizontal register having parallel inputs is present, for example, in the two-dimensional sensor devices of the interline type and of the Frame Transfer type mentioned above, as described inter alia in the chapter "Area Image Sensor" of the book "Charge Transfer Devices" by C.H. Séquin and M.F. Tompsett, Academic Press Inc. (1975), p. 152 ff.

Charge-coupled devices having parallel inputs are also present in other arrangements than those intended to convert a radiation pattern, for example, in an SPS memory, as described inter alia on pages 243 ff. of the aforementioned book of Séquin and Tompsett. In this case, the mostly binary information is stored in a parallel section of adjacent charge transport channels whose outputs are coupled via parallel inputs to a horizontal series reading-out register. Via the parallel inputs, the series reading-out register can be filled with a row of charge packets from the parallel section, after which these charge packets are transported via the horizontal series reading-out register to a detection element and read out there one by one.

The invention will now be described more particularly with reference to line sensors. However, it should be taken into account that the field to which the invention can be applied, as already indicated above, is considerably wider than only line sensors.

As known, in usual $n$-phase charge-coupled devices, $n$ is equal to 2, 3, or 4, that is to say that per 2, 3 or 4 adjacent clock electrodes one charge packet is present. In a simple embodiment, the pitch between two successive photosensitive elements (pixels) can be chosen to be equal to the length of a CCD cell. For a two-phase CCD, this length comprises two clock electrodes, for a three-phase CCD 3 clock electrodes and for a four-phase CCD 4 clock electrodes. In this situation, a single CCD line suffices to read out all charge packets originating from the sensor. This has the disadvantage that the resolution of the device is lower than is often desirable due to the large pitch between the pixels. The number of clock electrodes per pixel can be halved by using two CCD lines, which are provided on both sides of the row of pixels. With respect to the bit length in the CCD registers, the density of the pixels can be doubled by alternately connecting the pixels to the one CCD register and the other CCD register. Since also in this method the desired resolution is not yet reached, it has also been proposed already to use four CCD lines instead of two, in which event two CCD lines are provided beside each other on both sides of the sensor row. However, this method requires a rather complicated transfer of charge packets from the pixels to the two outermost registers.

Similar problems as described above for line sensors may also arise in two-dimensional image sensors and in SPS memories, in which lines of charge packets are transported _via_ a system of parallel vertical CCD lines to a horizontal reading-out register. In devices of this type, the optimum pitch between the parallel channels often does not correspond to the bit length in the horizontal reading-out register, as a result of which with the use of a single horizontal reading-out register more than one charge packet would be supplied in the reading-out register. Therefore, in image sensors a multiphase (two- or three-phase) reading-out register is frequently used. In SPS memories, the principle of "de-interlacing" can be used, in which event a line of information is subdivided into two halves which are sequentially introduced into the horizontal register and read out.

The present invention has _inter alia_ for its object to provide a method by which, whilst maintaining the number of parallel inputs per unit length, the number of clock electrodes can be reduced or, whilst maintaining the number of clock electrodes, the number of parallel inputs per unit length can be enlarged.

According to the invention, a charge-coupled device of the kind described in the opening paragraph is characterized in that the pitch between the parallel inputs is equal to $m$ electrodes, $m$ being an integer, smaller than $n$ and at least 1, in that means are provided with the aid of which during the introduction of charge packets voltages are supplied to the clock electrodes, at least at the area of the said first position in the charge transport channel a potential profile being obtained of potential wells mutually separated by potential barriers, whilst under each clock electrode which is associated with one parallel input a potential well is formed in which a charge packet can be stored, and in that the said means for supplying clock voltages for transporting the introduced charge packets supply such clock voltages that, viewed in the charge transport direction, first only the first charge packet is shifted over a distance of at least one electrode, after which only the first and the subsequent second charge packet are shifted simultaneously over the same distance, etc., wherein each time after a preceding charge packet has been shifted over the said distance, a next charge packet participates in the n-phase charge transport until also the last charge packet participates in the n-phase charge transport.

The invention is based on the recognition of the fact that, when charge packets are introduced in parallel, these charge packets can be stored in potential wells which need be mutually separated only by an intermediate potential barrier. On the contrary, during the usual two-, three- or four-phase transport, two adjacent charge packets are mutually separated not only by at least one potential barrier, but also by at least one intermediate free location which renders the charge transport possible. This means that, as long as no charge transport takes place, the charge packets can be stored with a higher density than is possible during the two-, three- or four-phase transport. When now the charge transport would then take place in the usual manner, in which event all charge packets are shifted simultaneously, the charge packets would be combined in part. This is prevented in that, as indicated above, first the distances between the charge packets are enlarged by gradually starting the charge transport from the first charge packet and by ensuring that each time one charge packet more participates in the charge transport. In this manner, it is possible to make the distances between the parallel inputs smaller than the length of one CCD bit during the charge transport, as a result of which in the case of a line sensor these distances correspond more accurately to the pitch between the pixels, whilst loss of information during the charge transport can be avoided.

The invention will be described more fully with reference . to a few embodiments and the accompanying diagrammatic drawing, in which:

Figure 1 shows a block circuit diagram of a line sensor;

Figure 2 is a plan view of a part of a line sensor according to the invention;

Figure 3 is a sectional view taken on the line III-JII of this line sensor;

Figure 4 is a sectional view taken on the line IV-IV of the sensor shown in Figure 2;

Figures 5 and 6 show two embodiments of the switches S used in the line sensor shown in Figure 2;

Figure 7 shows a diagram of the voltages used in the line sensor as a function of the time $t$;

Figure 8 shows potential profiles occuring with these voltages at a number of instants in the channel;

Figure 9 shows a block circuit diagram of a second embodiment of a line sensor according to the invention.

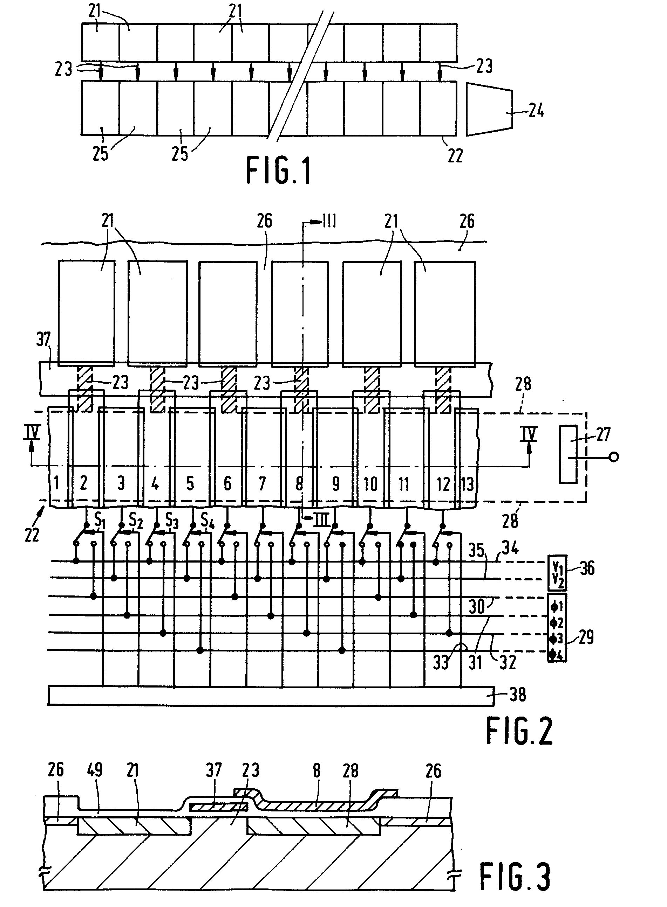

For explanation of the invention, Figure 1 shows in the form of a block circuit diagram a conventional line sensor or linear image sensor device, as can be used, for example, in facsimile image display arrangements. The device comprises the linear array of photosensitive elements 21 and a charge transfer device 22, which can be integrated together with the photosensitive elements in a common semiconductor body. The charge transfer device is provided with parallel inputs 23, _via_ which electrical charge, which is generated in the photosensitive elements, can be transported to the associated charge storage location in the charge-coupled device 22. These parallel inputs are indicated as arrows to express the charge transport. The device further comprises reading means 24 at the output of the charge transfer device 22, by which the electrical signals can be read out in series.

As is shown diagrammatically in Figure 1, the charge transfer device is composed of an array of successive stages or bits. These bits correspond to the number of clock electrodes which in a particular embodiment is the minimum number required for the storage and transport of one charge packet. For a four-phase CCD, this number is four electrodes, for a three-phase CCD three electrodes and for a two-phase CCD two electrodes. In conventional devices, at most one photosensitive element (pixel) can correspond to a CCD bit. With given dimensions in the charge transfer device 22, this requirement imposes serious limitations on the number of pixels that can be provided per unit length.

Figure 2 is a plan view of an embodiment of a line sensor according to the invention, in which as compared with the sensor shown in Figure 1 a two times higher pixel density is possible. The device comprises again a linear array of photosensitive elements 21 which, at least viewed in the plane of the drawing, are each limited substantially along their whole circumference and are mutually separated by limiting regions 26. Beside the row of pixels 21, again a CTD is arranged, in this embodiment a four-phase CCD (charge-coupled device). The charge transport channel 28, which terminates at the output 27, is indicated by broken lines in Figure 2. Above the charge transport channel clock electrodes 1 - 13 are provided for inducing potential wells and potential barriers in the channel 28. The clock voltages $\emptyset_1$, $\emptyset_2$, $\emptyset_3$ and $\emptyset_4$, which are required to transport the charge through the channel 28 to the output, are supplied by the clock voltage source 29, which can be connected via clock lines 30, 31, 32 and 33 to the clock electrodes. In contradistinction with usual CCD's, clock electrodes are not connected to the clock lines through a fixed connection, but via switches $S_1$, $S_2$, $S_3$ etc., by means of which the clock electrodes can be connected to line 34 or line 35. Via these lines, the voltages $V_1$ or $V_2$ supplied by the voltage source 36 can be applied to clock electrodes. The values of $V_1$ and $V_2$ will be referred to hereinafter. The switches $S_1$, $S_2$, $S_3$ etc. are driven by a shift register 38, by means of which the switches S can be changed over from the right to the left in order of succession from the voltage source 36 to the clock voltage source 29.

The CCD channel is connected to the pixels 21 via the parallel inputs 23 shown by hatched lines and consisting of interruptions in the limiting zone 26. A transfer gate 37 is arranged above the parallel inputs 23 for controlling the charge transport between the pixels 21 and the channel 28. As appears from the drawing, the number of parallel inputs 23 and the number of associated pixels amount to two for each four successive clock electrodes instead of one, as is usual in four-phase CCD's.

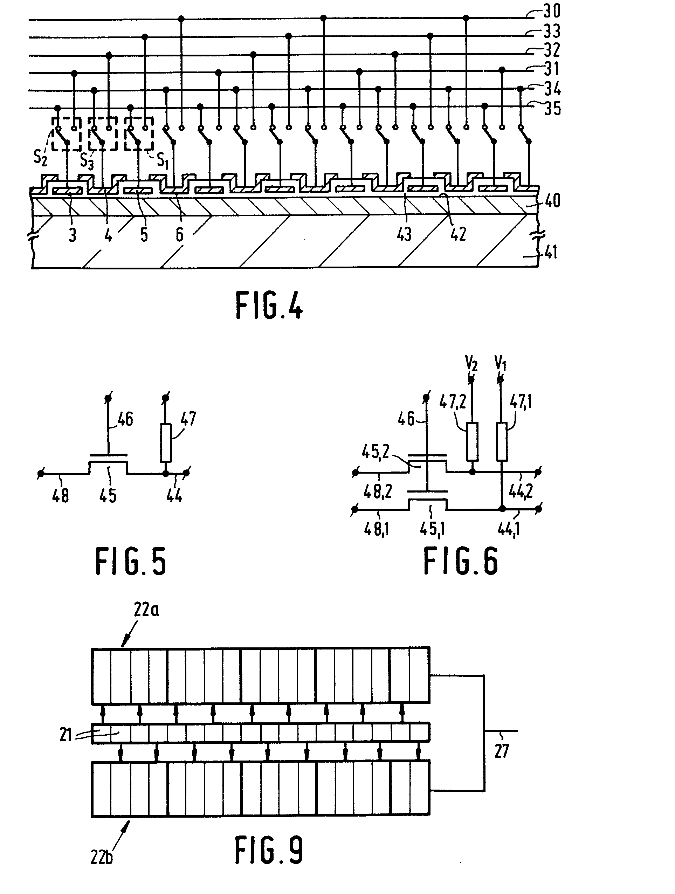

Figure 4 is a sectional view of a part of the charge-coupled device. The device is of the BCCD or PCCD type and comprises a comparatively thin surface layer 40 of the n-type, which constitutes the charge transport channel of the charge-coupled device and is limited on the lower side by a p-type region 41. In the present embodiment, the p-type region 41 constitutes the starting semiconductor body, which is provided at its surface with the thin n-type surface layer 40. However, it is alternatively possible that the region 41 is also constituted by a comparatively narrow region, which passes again into an n-type substrate region on the lower side via a pn junction. The surface 42 is covered by an insulating layer 43 of, for example, silicon oxide on which the clock electrodes 3, 4, 5, 6 etc. are arranged. The electrodes 3, 5, 7 etc. can be formed in a first polycrystalline silicon layer; the electrodes 4, 6, 8 etc., which overlap the first-mentioned electrodes, can be made of a second polycristalline silicon layer or metal layer. Figure 4 moreover shows again diagrammatically the clock lines 30-33 and the lines 34, 35 for applying the d.c. voltages $V_1$ and $V_2$ and the switches S.

Figure 3 is a sectional view at right angles to the charge transport direction of a part of the device, which part comprises a pixel 21, the transfer gate 37 and the charge transport channel 28. The pixel 21 comprises an n-type surface zone formed in the p-type body 41. The zone 21 is limited substantially along its whole circumference by a channel-limiting p-type zone 26, whose doping concentration is higher than that of the body 41 and is chosen sufficiently high to prevent channels, which could interconnect adjacent pixels, from being formed. The zone 26 leaves free only under the gate 37 a channel 23 which constitutes one of the said parallel inputs to the charge transport channel 28. As is indicated in Figure 3, the transfer gate 37 is formed in the lowermost (first) polycristalline silicon layer, while the CCD clock electrode associated with the parallel input 23 is formed in the second polycristalline silicon layer (or Al layer). Of course, instead of a doped zone 21, also an induced photosensitive zone 21 may be used, in which event there is formed on the oxide layer 49 above the photosensitive region an insulated gate electrode, by means of which a depletion zone is induced in the subjacent photosensitive region.

Figures 5 and 6 show two possible embodiments of the switches S. In the embodiment shown in Figure 5, each switch is individually constituted by a MOS transistor 45, whose gate 46 is connected to and is driven by the shift register 38. The associated clock electrode is connected to the one main electrode region, i.e. the main electrode region 44. Via a resistor 47, this main electrode region is connected to the line 34 or 35 for applying the desired d.c. voltage $V_1$ or $V_2$. The other main electrode region 48 is connected to the associated clock line 30-33 for applying $\emptyset_1$, $\emptyset_2$, $\emptyset_3$ or $\emptyset_4$ to the corresponding clock electrode. In this embodiment, the switches S are all coupled separately to the shift register. Figure 6 shows a variation, in which each time two successive switches S are provided with the common gate 46, in which event a switch $S_i$ is constituted by the transistor 45,1 and the switch $S_{i+1}$ is constituted by the transistor 45,2. The main electrode region 44,1 is connected via the resistor 47,1 to $V_1$ and the main electrode region 48,1 is connected to clock line 30 (32). The main electrode region 44,2 is connected via the resistor 47,2 to the d.c. voltage $V_2$. The main electrode region 48,2 is connected to the clock line 31 (33). It should be noted that in this embodiment each time two consecutively arranged switches are changed over simultaneously, which, as will appear hereinafter, is possible without the use of further means in the present four-phase embodiment.

The switches S can be driven by a shift register 38 of a type as described inter alia in the book "Introduction to Switching Theory and Logical Design" by F.H. Hill and G.R. Petersen, Wiley Int. Ed. John Wiley and Sons, 1974, more particularly Chapter 9.4, pages 221-223 "Shift Registers and Counters".

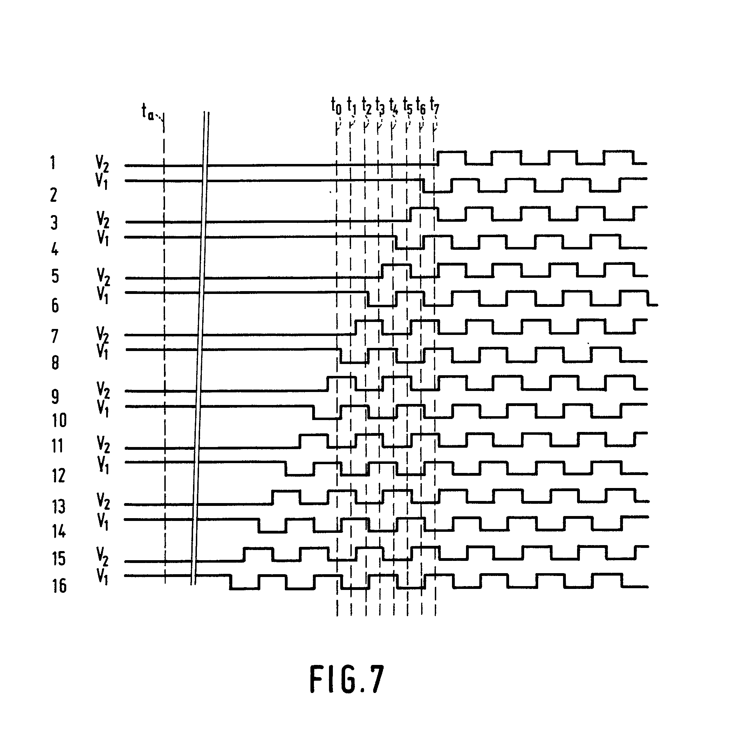

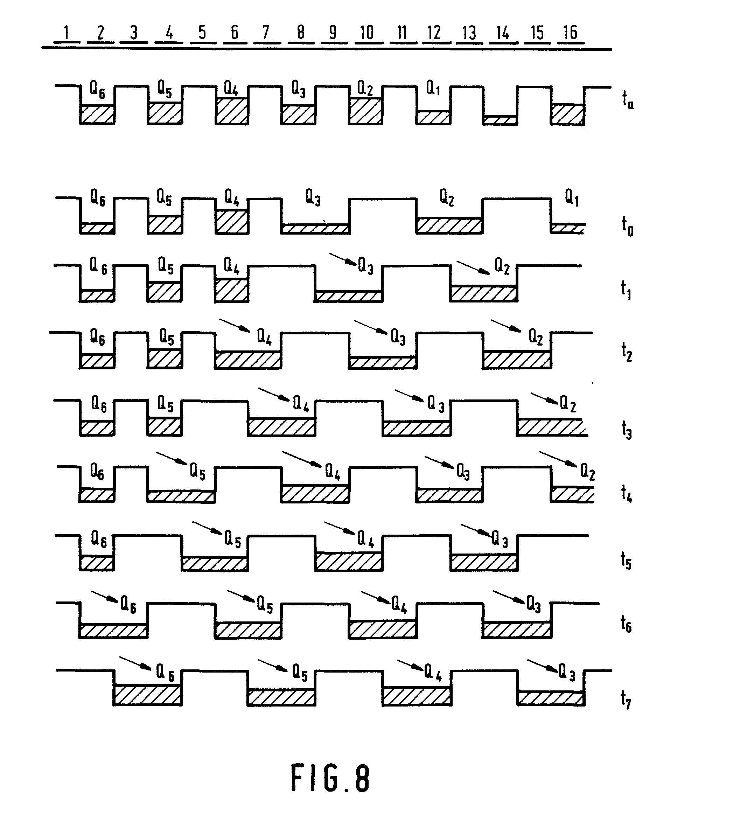

For illustration of the operation of the device, Figure 8 shows the potential distribution under sixteen successive clock electrodes 1-16 during operation. Figure 7 shows the voltages applied as a function of the time $\underline{t}$. First a radiation pattern is converted into a pattern of charge packets in the array of photodiodes 21. The switches S are then all set to that position in which the clock electrodes 1, 2, 3 etc. are connected to the voltage source 36. A low voltage $V_2$ is applied to the odd-numbered electrodes (1, 3, 5 etc.) so that a potential barrier for electrons is formed under these electrodes. A higher voltage $V_1$ is applied to the even-numbered electrodes so that a potential well is formed under these electrodes. When a positive pulse is then applied to the transfer gate 37, the packets stored in the pixels 21 can be transported to the potential wells under the clock electrodes 2, 4, 6, 8 etc. This situation is shown in Figures 7 and 8 at instants $t_a$. As appears from the Figures, a charge packet is now stored every other electrode. For each four electrodes two charge packets are consequently present, which are mutually separated by a potential barrier which corresponds to a single clock electrode. Due to this dense charge storage it is possible to double the number of pixels per unit length as compared with conventional four-phase devices.

Since the number of charge packets is too high for the usual four-phase mode of operation, first only the first charge packet, _i.e._ the charge packet which is closest to the output 24, is shifted (and, as the case may be, read out), after which also the clock electrodes associated with the next charge packet are clocked. When the distance between this charge packet and the subsequent charge packet is sufficiently large, also the last-mentioned charge packet can be transported by changing over the associated switches S. In order to illustrate this, Figure 8 shows potential distributions during this shifting charge transport at a number of instants $t_0 - t_7$. The starting instant is the instant $t_0$ (see also Figure 7), at which the electrodes 7-16 (or 8-16) are clocked, while the electrodes 1-16 are at one of the fixed voltages $V_1$ and $V_2$. The charge packets $Q_1$, $Q_2$ and $Q_3$ participate in the transport in this situation, while the charge packets $Q_4$, $Q_5$ and $Q_6$ are still stationary. It should be noted that the four-phase mode of operation is carried out with the known so-called overlapping clocks, wherein in a group of four successive electrodes a potential well is formed under two electrodes and a potential barrier is formed under the two remaining electrodes, as a result of which invariably two electrodes are available for a charge packet during the transport.

At the instant $t_1$, the charge packet $Q_3$ is stored under the electrodes 9 and 10 and is separated from the next charge packet $Q_4$ by a potential barrier under the electrodes 7 and 8. The switch $S_6$, which is connected to the clock electrode 6 (or the switches $S_6$ and $S_7$), can then be changed over, as a result of which $Q_4$ also can participate in the normal four-phase charge transport (instant $t_2$). At $t_3$, the distance $Q_4$-$Q_5$ is again sufficiently large to cause the charge packet $Q_5$ to participate in the charge transport by changing over the switches $S_4$, $S_5$. At $t_4$, $Q_5$ has already been shifted in part under the clock electrode 5. Simultaneously with $Q_5$, the charge

packets $Q_4$, $Q_3$, $Q_2$, $Q_1$ are also shifted in the usual four-phase charge transport mode. Only $Q_6$ does not yet participate at this instant in the charge transport. At the instant $t_5$, $Q_5$ has arrived under the electrodes 5 and 6 so that the distance between $Q_5$ and $Q_6$ is sufficiently large to shift also $Q_6$. At the instants $t_6$ and $t_7$, the situation is shown in which all charge packets $Q_3-Q_6$ are transported simultaneously. It is required for the mode of charge transport described above to change over consecutively the switches S (Figure 2) from the lines 34, 35 (i.e. voltage) to the clock lines 30-33, that is to say from the right to the left. For this purpose, there can be supplied to the input of the shift register 38 described above (on the righthand side) a sequence of input signals "1", which are shifted to the left by the clock associated with the shift register. The frequency of this clock with the use of single switches as shown in Figure 5 is four times the frequency of the clocks $\emptyset_1$, $\emptyset_2$, $\emptyset_3$, $\emptyset_4$. With the use of the double switch as shown in Figure 6, the frequency of the clock of the shift register can be halved.

Figure 9 shows a circuit diagram of an embodiment in which as compared with the embodiment described hereinbefore a further increase of the number of pixels can be obtained. Instead of one CCD line, two CCD lines 22a and 22b are used above and below the row of pixels 21. The charge-coupled devices may each be of the same construction as the charge-coupled device in the preceding embodiment and are assumed to be of the four-phase type. Each bit, which comprises four electrodes, is indicated by heavy lines, while the clock electrodes are indicated by the thin lines. The pixels are now alternately connected to the upper register 22a and to the lower register 22b. Per bit again two charge packets can be introduced into the registers 22a and 22b. The charge packets introduced into the registers can be transported to the output 27 in the same manner as in the first embodiment. As compared with the first embodiment, the number of pixels per unit length can be doubled due to the use of two charge-coupled devices. As a matter of course, this number may be further increased by providing a third and a fourth register above and below the register 22a and 22b, respectively.

It will be appreciated that the invention is not limited to the embodiments shown here, but that many variations are still possible for those skilled in the art without departing from the scope of the invention. For example, the invention may be used besides in the line sensors described here in all types of charge-coupled devices having parallel inputs. Further, the invention may be used in three-phase and two-phase charge-coupled devices. Besides charge-coupled devices, also other types of charge transfer devices, such as bucket brigade registers, may be used.

The switches S and the shift register 38 may be replaced by a shift register as described in the copending application in the name of the Applicant "Charge-coupled device with dynamic control" (PHN 10.997).

1.      A charge-coupled device comprising a semiconductor body
having a surface-adjoining semiconductor region in which a charge
transport channel for storing and transporting information-representing
discrete charge packets is defined, which device further comprises
a system of clock electrodes which are located above the charge
transport channel and which are connected to means for supplying clock
voltages for transporting the said charge packets from a first position
in the charge transport channel to a second position in such a manner
that per $n$ successive clock electrodes only one charge packet is
present, $n$ being an integer and smaller than or equal to two, the
charge transport channel further being provided with a number of
parallel inputs which each correspond to at least one of the said
clock electrodes and by means of which charge packets can be supplied
in parallel to the charge transport channel, characterized in that the
distance between two adjacent parallel inputs is about equal to $m$
electrodes, $m$ being an integer, smaller than $n$ and at least 1, in
that means are provided by means of which during the introduction of
charge packets voltages are supplied to the clock electrodes, at
least at the area of the said first position in the charge transport
channel a potential profile being obtained of potential wells mutually
separated by potential barriers, under each·clock electrode
associated with one parallel input a potential well being formed in
which a charge packet can be stored, and in that the said means for
supplying clock voltages for transporting the introduced charge
packets supply such clock voltages that, viewed in the charge transport
direction, first only the first charge packet is shifted over a distance
of at least one electrode, after which only the first and then the
second charge packet are shifted simultaneously over the same distance,
etc., wherein each time after a preceding charge packet has been
shifted over the said distance, a next charge packet participates
in the $n$-phase charge transport until also the last charge packet
participates in the $n$-phase charge transport.

2.      A charge-coupled device as claimed in Claim 1, characterized in that beside the charge transport channel a linear array of photosensitive elements is provided, which are connected to the charge transport channel via the parallel inputs.

3.        A charge-coupled device as claimed in Claim 2, characterized in that the linear array of photosensitive elements constitutes a line sensor.

1/4

FIG.1

FIG.2

FIG.3

0159758

2/4

FIG.4

FIG.5

FIG.6

FIG.9

2 -IV- PHN 10998

FIG.7

FIG.8

4-Ⅳ-PHN 10998

0159758

European Patent
Office

**EUROPEAN SEARCH REPORT**

. Application number

EP 85 20 0580

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | US-A-4 178 614 (D.J. SAUER)<br>* Figures 10-12; column 8, line 54 - column 11, line 10 * | 1 | H 01 L 27/14 |
| A | US-A-4 131 950 (J.G. VAN SANTEN)<br>* Figures 1-3; column 5, line 1 - column 6, line 58 * | 2,3 | |
| P,X<br>D | EP-A-0 128 615 (N.V. PHILIP'S GLOEILAMPENFABRIEKEN)<br>* Figures 2-5 * | 1 | |

TECHNICAL FIELDS
SEARCHED (Int. Cl.4)

H 01 L

The present search report has been drawn up for all claims

| Place of search<br>THE HAGUE | Date of completion of the search<br>06-06-1985 | Examiner<br>CARDON A. |
|---|---|---|